# EUROPEAN PATENT APPLICATION

(11) **EP 1 026 927 A2**
(43) Date of publication of application: **09.08.2000**
(21) Application number: 00300407.4
(22) Date of filing: 20.01.2000
(51) Int. Cl.: H05K 1/11

(54) **Special bond pad configurations for printed circuit boards**

(30) Priority: 08.02.1999 US 246863
(71) Applicant: Ford Motor Company, Dearborn, MI 48126 (US)
(72) Inventor: Goenka, Lakhi Nandlal, Ann Arbor, Michigan 48103 (US)
(74) Representative: Messulam, Alec Moses

(57) **Abstract**

A circuit board having special bond pad configurations which mitigate against both reflow-induced skew and bond pad delamination, especially for fine-pitch applications. The circuit board comprises: (1) an electrically insulative substrate 16; and (2) a plurality of bond pads 20 disposed side-by-side in a generally straight row on the substrate, wherein the row defines a width direction therealong and a length direction orthogonal thereto. Each bond pad 20 has an overall width W as measured along the width direction and an overall length L as measured along the length direction, such that L > W. Each pad 20 also has an overall left edge 22 and an overall right edge 24 running generally along the overall length of each respective pad, such that at least one of the edges of each pad is non-straight or is oblique with respect to the length direction. The adjacent edges of adjacent pads generally dovetail, interdigitate, or otherwise conform in shape with each other, such that at least one portion of each pad has a width Wₘᵢₙ wide enough to avoid delamination of the pad, while the remainder of each pad is narrow enough that skewing of the component leads during reflow is avoided.

## Description

The present invention relates generally to printed circuit boards, and more particularly to printed circuit boards having special bond pad configurations.

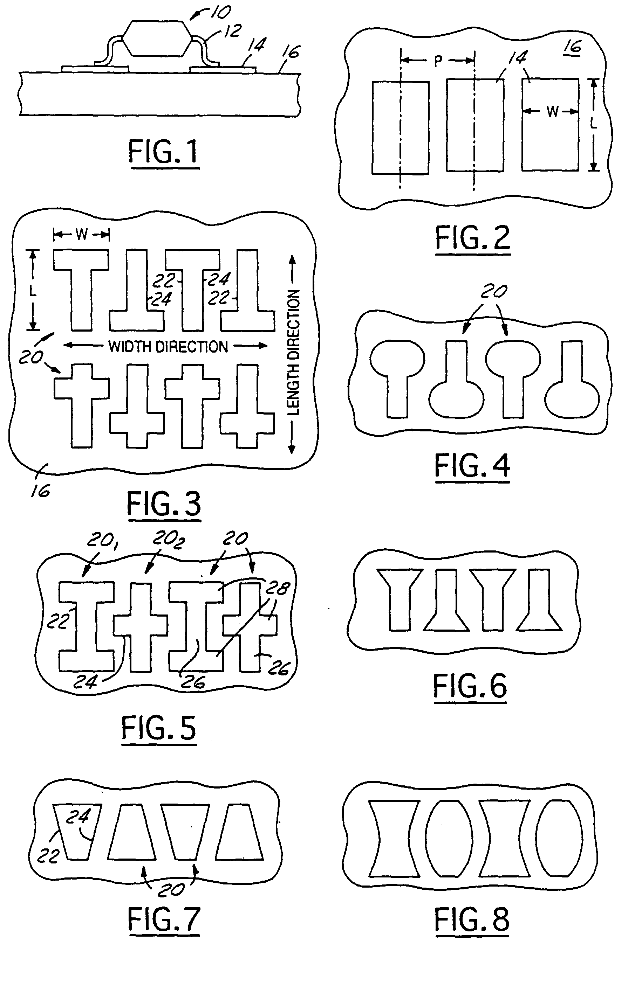

Electronic components such as the device 10 shown in FIGS. 1-2 are commonly used on printed circuit boards (PCBs). The device shown here is a small-outline integrated circuit (SOIC) having gull-wing leads 12 which rest on respective bond pads 14 on the PCB surface 16. In some instances, otherwise normally sized pads 14 may be too large, and, in conjunction with surface tension forces in the molten solder paste, may cause the leads 12 (and hence the component 10) to skew or rotate on the pads during reflow. This can cause some leads to rotate/skew entirely off their pads, causing open circuits and a failed PCB.

A typical way of addressing this problem is to make the pads smaller (i.e., more narrow). However, as the bond pads are made narrower, they have an increased tendency to delaminate from the underlying substrate. Delamination is particularly a concern for fine-pitch applications where the bond pads must necessarily be made narrow in the first place. It is also a particular problem for etched tri-metal-layer circuit boards, such as those disclosed in U.S. Pat. Nos. 4,404,059 to Livshits et al. (hereinafter "Livshits"), 3,801,388 to Akiyama et al. (hereinafter "Akiyama"), and 5,738,797 to Belke et al. (hereinafter "Belke"), all three of which are incorporated herein by reference; however, delamination of narrowed pads is also a problem with other types of PCBs as well. It would desirable, therefore, to provide a way of avoiding the aforementioned skew problems, while also avoiding the increased tendency toward delamination.

The present invention provides a circuit board having special bond pad configurations which mitigate against both reflow-induced skew and bond pad delamination, especially for fine-pitch applications. The circuit board comprises: (1) an electrically insulative substrate; and (2) a plurality of bond pads disposed side-by-side in a generally straight row on the substrate, wherein the row defines a width direction therealong and a length direction orthogonal thereto. Each bond pad has an overall width W as measured along the width direction and an overall length L as measured along the length direction, such that L > W. Each pad also has an overall left edge and an overall right edge running generally along the overall length of each respective pad, such that at least one of the edges of each pad is non-straight or is oblique with respect to the length direction.

It is an advantage that in the present invention, the adjacent edges of adjacent pads generally dovetail, interdigitate, or otherwise conform in shape with each other, such that at least one portion of each pad has a width wide enough to avoid delamination of the pad, while the remainder of each pad is narrow enough that skewing of the component leads during reflow is avoided.

Another advantage is that the present invention may be utilized with all types of circuit boards, including FR-4, ceramic, flex, and etched-tri-layer metal PCBs.

The invention will now be described further, by way of example, with reference to the accompanying drawings, in which:
FIG. 1 is a side view of a PCB with bond pads and an electronic component thereon as claimed in the prior art;
FIG. 2 is a top view of typical bond pad configurations as claimed in the prior art;
FIGS. 3-14 are top views of various bond pad configurations as claimed in the present invention; and
FIGS. 15-17 are top schematic views of various bond pad configurations as claimed in the present invention.

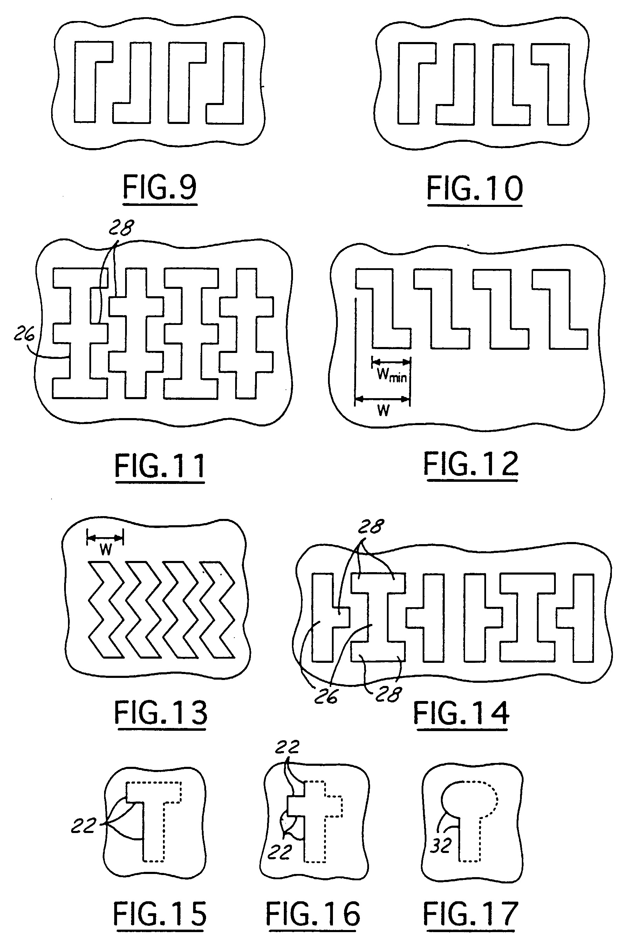

Referring now to the drawings, FIGS. 3-17 show various circuit board bond pad configurations as claimed in the present invention which mitigate against both ref low-induced skew and delamination, especially for fine-pitch applications. The circuit board comprises: (1) an electrically insulative substrate 16; and (2) a plurality of bond pads 20 disposed side-by-side in a generally straight row on the substrate, wherein the row defines a width direction therealong and a length direction orthogonal thereto. Each bond pad 20 has an overall width W as measured along the width direction and an overall length L as measured along the length direction, such that L > W. Each pad 20 also has an overall left edge 22 and an overall right edge 24 running generally along the overall length of each respective pad, such that at least one of the edges of each pad is non-straight or is oblique with respect to the length direction. The adjacent edges of adjacent pads generally dovetail, interdigitate, or otherwise conform in shape with each other, such that at least one portion of each pad has a width Wₘᵢₙ wide enough to avoid delamination of the pad, while the remainder of each pad is narrow enough that skewing of the component leads during reflow is avoided.

To assist the reader in understanding the present invention, all reference numbers used herein are summarized in the table below, along with the elements they represent:
- 10 =: Electronic component
- 12 =: Leads of electronic component
- 14 =: Bond pads on substrate (prior art)
- 16 =: Electrically insulative substrate
- 20 =: Bond pads as claimed in the present invention
- 20₁ =: First pad (adjacent to second pad)
- 20₂ =: Second pad (adjacent to first pad)
- 22 =: Overall left edge of pad
- 24 =: Overall right edge of pad
- 26 =: Main/longitudinal body of pad
- 28 =: Finger/digit extending outward from pad
- 30 =: Portion(s) of pad having minimum width Wₘᵢₙ
- L =: Overall length of pad
- P =: Centerline-to-centerline pitch of bond pads
- W =: Overall width of pad
- Wₘᵢₙ =: Minimum width of pad to avoid delamination

As illustrated particularly in FIGS. 15-17, each overall left or right edge 22/24 may comprise one or more contiguous "edges". For example, in the configurations shown in FIGS. 15-16, note that the left overall edge 22 (drawn with bold lines) comprises three and five straight edges, respectively, while the overall left edge 22 of FIG. 17 comprises one straight edge and one arcuate (C-shaped) edge.

In each of the pad configurations of the present invention, one or both of the overall edges 22/24 should be either non-straight (e.g., curved, stair-stepped, zig-zagged, etc.), or oblique (i.e., non-parallel) with respect to the length direction, or both. For the "non-straight" limitation, note that the "overall" edge must be non-straight, although the overall edge may comprise multiple straight segments that connect together to form an "overall" non-straight edge 22/24. For example, the left edge 22 of FIG. 16 is non-straight overall, although it comprises five contiguous straight individual segments. As for the "oblique" limitation, note in FIG. 7 that although both of the overall edges 22/24 are straight, at least one (and in this case, both) of the edges 22/24 is oblique/non parallel with respect to the length direction.

With one or both overall edges 22/24 configured as described above, it is preferable that the adjacent overall edges 22/24 of adjacent pads 20 generally dovetail, interdigitate, or otherwise conform in shape with each other. (In other words, the overall left edge 22 of a first one 20₁ of the pads generally conforms in shape with the adjacent overall right edge 24 of a second, adjacent one 20₂ of the pads.) For example, the adjacent edges 22/24 of the pads shown in FIG. 14 have "fingers" or "digits" 28 which extend outward generally in the width direction from the main/longitudinal body 26 of the pad, wherein the adjacent fingers 28 of the pads generally interdigitate with one another. In other configurations where the adjacent edges 22/24 of adjacent pads 20 have only one digit or finger 28, such as those in FIGS. S and 11, the fingers/pads are arranged such that the fingers and general contour of the adjacent edges 22/24 generally conform with and complement each other, such as by presenting the pads in a repeating upright-inverted pattern.

Regardless of which particular configuration is used, at least one portion 30 of each pad should have a width Wₘᵢₙ wide enough to avoid delamination of the pad, with the remainder of the pad being generally narrow enough to avoid skewing of the component leads during reflow. The minimum width Wₘᵢₙ is generally the smallest width that the pad can have locally and reliably avoid delamination of the pad from the underlying substrate under the expected processing and field conditions for the PCB; therefore, this width Wₘᵢₙ will typically depend on a variety of variables. For example, for etched tri-metal-layer air bridge circuit boards (as disclosed in Akiyama, Livshits, and Belke), where the tri-layer-metal circuit comprises a 2-mil-copper/6-mil-aluminum/2-mil-copper structure (i.e., the lower circuit traces and upper bridge crossovers are 2-mil copper and the middle bridge pedestals/support elements are aluminum), Wₘᵢₙ is in the neighborhood of 35 mils. That is, one on more portions 30 of each pad 20 should be at least 35 mils wide so that at least that portion 30 does not delaminate; for the remaining portions of the pad, the local width thereof may go down as low as 20 mils, for example. With most of the pad 20 being only 20 or so mils wide, the component leads are much less likely to skew thereon during reflow. Although these thinner portions may be subject to delamination, the wide portions 30 whose width is Wₘᵢₙ or greater will not likely delaminate; thus while some portion of the pad may delaminate, the pad as a whole will be kept attached to the underlying substrate by the wider portions 30.

As illustrated by FIGS. 3-17, the pads as claimed in the present invention may assume many different configurations. For a given configuration, the pads 20 may be generally the same geometric shape, or they may assume two or more geometrically complementary shapes such that their adjacent overall edges 22/24 generally conform with each other. The pads may be generally L-shaped, Z-shaped, chevron-shaped, zig-zag-shaped, or the like, with each oriented identically or with every other pad inverted with respect to the others. Other configurations include generally T-shaped, t-shaped, Y-shaped, triangular, trapezoidal, spoon/spade/shovel-shaped, and the like. The general configuration may also include a repeating first shape/second shape pattern, wherein each of the pads exhibits either a first shape or a second shape. For example, the first and second shapes may be generally I-shaped and t-shaped, respectively, as in FIG. 5, or generally hourglass-shaped and generally barrel-shaped, as in FIG. 8. Also, there may be a repeating first/second/third shape pattern, such as that shown in FIG. 14, where (1) the first shape is generally shaped as an elongate member 26 (running generally parallel with the length direction) having a branch member or digit 28 extending toward an adjacent pad of the second shape, (2) the second shape is generally I-shaped, and (3) the third shape is generally a mirror image of the first shape (with the branch/digit of the third shape extending in a direction opposite that of the first shape's branch/digit).

Various other modifications to the present invention may occur to those skilled in the art to which the present invention pertains. For example, although care has been taken to illustrate several different pad configurations in the drawings, including those which should prove most useful, it should be realized that many more configurations are possible which are within the scope of the present invention; thus, other modifications not explicitly mentioned herein are also possible and within the scope of the present invention. Also, it should be apparent that the overall width W for the present invention configurations shown in the drawings is at least Wₘᵢₙ wide, so that delamination is mitigated.

## Claims

1. A circuit board, comprising:
an electrically insulative substrate (16); and
a plurality of bond pads (20) disposed side-by-side in a generally straight row on said substrate (16), said row defining a width direction therealong and a length direction orthogonal thereto;
wherein each bond pad (20) has an overall width W as measured along said width direction and an overall length L as measured along said length direction, such that L > W;
wherein each pad has an overall left edge (22) and an overall right edge (24) running generally along the overall length of each respective pad, such that at least one of said edges of each pad is non-straight or is oblique with respect to said length direction;
wherein the overall left edge (22) of a first one of said bond pads generally conforms in shape with the adjacent overall right edge (24) of a second, adjacent one of said bond pads.

2. A circuit board as claimed in claim 1, wherein each of said bond pads exhibits generally the same geometric shape.

3. A circuit board as claimed in claim 2, wherein said geometric shape is generally L-shaped, generally Z-shaped, generally chevron-shaped, or generally zig-zag-shaped.

4. A circuit board as claimed in claim 2, wherein every other pad is inverted in shape.

5. A circuit board as claimed in claim 4, wherein said geometric shape is generally L-shaped, generally T-shaped, generally t-shaped, generally Y-shaped, generally triangular, generally trapezoidal, or generally spoon-shaped.

6. A circuit board as claimed in claim 1, wherein each of said bond pads exhibits one of a first shape and a second shape, with said pads being arranged in a repeating first shape/second shape pattern.

7. A circuit board as claimed in claim 6, wherein said first shape is generally I-shaped and said second shape is generally t-shaped.

8. A circuit board as claimed in claim 6, wherein said first shape is generally hourglass-shaped and said second shape is generally barrel-shaped.

9. A circuit board as claimed in claim 1, wherein each of said bond pads exhibits one of a first shape, a second shape, and a third shape, with said pads being arranged in a repeating first shape/second shape/third shape pattern.

10. A circuit board as claimed in claim 9, wherein said first shape is generally shaped as an elongate member having a branch member extending toward an adjacent pad of said second shape, said second shape is generally I-shaped, and said third shape is generally a mirror image of said first shape.
